# EUROPEAN PATENT SPECIFICATION

(11) **EP 0 350 484 B1**
(45) Date of publication and mention of the grant of the patent: **29.09.1993**
(21) Application number: 88901335.5
(22) Date of filing: 19.01.1988
(51) Int. Cl.: H02N 2/00

(54) **METHOD AND DEVICE IN MAGNETOSTRICTIVE MOTION SYSTEMS**
VERFAHREN UND ANORDNUNG BEI MAGNETOSTRITIVEN BEWEGUNGSSYSTEMEN
PROCEDE ET DISPOSITIF POUR SYSTEMES DE MOUVEMENT MAGNETOSTRICTIF

(30) Priority: 21.01.1987 SE 8700219
(43) Date of publication of application: 17.01.1990
(73) Proprietor: JACOBSSON INDUSTRIER I STOCKHOLM AB, S-431 40 Mölndal (SE)
(72) Inventor: KIESEWETTER, Lothar, Erik, D-1000 Berlin 42 (DE); OLSSON, Fredy, S-211 47 Malmö (SE); TYR N, Carl, H., S-223 76 Lund (SE)
(74) Representative: Ström, Tore
(86) International application number: SE8800010
(87) International publication number: WO8805618

(56) References cited:
- DE-A-19 332 05
- GB-A- 2 174 554
- US-A- 4 017 754
- US-A-25 061 41
- Patent Abstracts of Japan, Abstract of JP-53-27103 published 1978-03-14
- Elteknik med Aktuell electronik 1984:16, Jansson Leif, " Jättemagnetostriktion ger känsligare givare", see p. 57.

## Description

The present invention relates to a method of causing a first body, having magnetostrictive properties, and a second body, against which said first body is in bearing contact with a predetermined grip between the contact surfaces, to move with respect to each other, and a device for carrying out the method.

US 2 506 141 describes a device which makes it possible to obtain automatically a succession of very small displacements for a mechanical piece comprising two carriages connected to one another by a bar made of magnetostrictive material, for instance nickel. Said carriages interconnected by said bar are supported on a bench upon which the movable equipment thus constituted may be caused to perform a sliding movement. The magnetostrictive bar is surrounded by a magnetic coil. When the magnetic coil is excited, said bar undergoes a contraction. Both carriages are provided with electromagnets for at will locking said carriages on the bench. By alternately activating the two carriages in coordination with contraction respective return to normal dimensions of said bar, the unit comprising said carriages and said bar may be caused to perform a micro-displacement on the supporting surface of said bench.

One object of the present invention is to provide a method and a device of the kind mentioned initially in which said grip between the bodies is substantially maintained during said movement, and which is adapted for use in linear motors in which high precision of the resulting movement is required, e.g. adjusting motors wherein the requirements with respect to length of stroke and power output are small, but also in such linear motors in which larger stroke and power output is required, e.g. motors used as power and motion generating units in the operation of lifting devices. A further object of the invention is to provide a method and a device of the kind mentioned initially, which in a simple manner renders possible a finely adjustable and accurate control of the intended movement.

These and other objects of the invention are obtained by means of a method and a device having the characteristics specified in the appended claims.

The invention is described below with reference to the embodiments illustrated schematically on the appended drawings.

Figures 1A-1G illustrate very schematically and step by step the realization of the method according to the invention with reference to an embodiment including a magnetostrictive rod which by shrinking fit is disposed within a tubular body.

Fig 2 is a longitudinal section through a schematically illustrated translation motor for carrying out the method according to the invention.

Fig 3 illustrates schematically the magnetostrictive rod included into the translation motor of fig 2 and the preloading of said rod.

The present invention is based on the fact, that magnetostrictive materials change their geometrical dimensions under the influence of a magnetic field. A rod of magnetostrictive material of a certain composition will thus undergo an increase in length under the influence of a magnetic field at the same time as the transverse dimensions of the rod decrease.

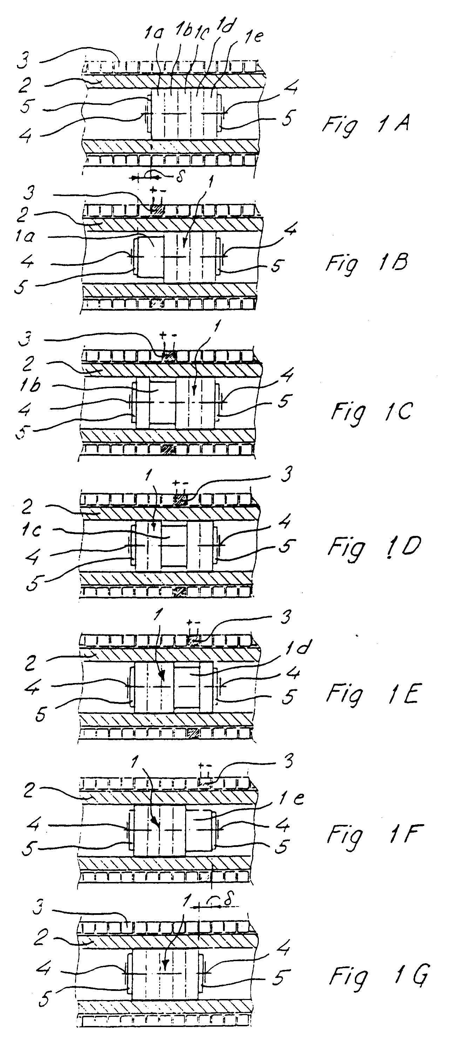

The method according to the invention utilises this phenomenon, which will be explained in more detail in the following under reference to the schematic figures 1A-1G.

In the embodiments illustrated in said figures, a cylindrical rod 1 of a magnetostrictive material of the kind which undergoes a simultaneous change in length and transversal contraction under the influence of a magnetic field, is by means of shrinking disposed within a cylindrical tube 2, preferably of a non-magnetic material, so that the magnetostrictive rod 1 is clamped within the tube 2 with a certain clamping grip. Along the entire length the rod 2 is surrounded by a great number of magnetic coils 3 disposed adjacent each other, each one of said coils being connectable sequentially, one after the other, to a current supplying source for generating a magnetic field. Each magnetic coil 3 is dimensioned so as to generate a magnetic field influencing only a partial region of the magnetostrictive rod 2. For facilitating the understanding, the magnetostrictive rod illustrated in figures 1A-1G has been divided into five regions 1a-1e disposed adjacent each other, the dividing line between adjacent region being marked as a dash-and-dot line. Each region 1a-1e is presupposed to correspond to the length of the rod 1 which is influenced by the magnetic field generated by one of the coils 3. Each magnetic coil 3 is designed so that the magnetic field generated when current is supplied to the coil, causes an increase in length of the region being influenced, the region simultaneously undergoing a transverse contraction of such a magnitude that the clamping grip against the tube 2 decreases considerably and preferably is eliminated. The magnetostrictive rod 1 is further prestressed in a direction opposite the direction of the change in length under the influence of the magnetic field. The object of said prestressing is to eliminate the influence i.a. of mechanical hysteresis, so that no remaining dimensional change of the magnetostrictive rod is obtained when the influence of the magnetic field ceases. The prestressing may e.g. be accomplished by means of a bolt 4 extending axially through the magnetic rod, so that said bolt when being tightened generates a compression force in the magnetostrictive rod, the traction force of the bolt 4 being transmitted to the rod 1 via two end washers 5 positioned on opposite end surfaces of the rod 1.

Fig 1A illustrates the device in rest position. No one of the magnetic coils 3 is supplied with current, and the magnetostrictive rod 1 is thus firmly clamped within the surrounding tube 2 with a predetermined clamping grip. The initial clamping grip, i.e. the clamping grip at unloaded condition, is chosen to have a predetermined value which then may be subject to variations depending of the load upon the device.

Fig 1B illustrates the condition resulting from a supply of current to the magnetic coil 3 situated just opposite, i.e. in the same transversal plane as the first region 1a of the magnetostrictive rod 1 as seen in the intended direction of movement. The region 1a is thereby subjected to an increase in length, illustrated in the figure in greatly enlarged scale, the region simultaneously undergoing a contraction in the transverse direction, so that the clamping grip of the region against the inside of tube 2 is eliminated, as illustrated in the figure in greatly enlarged scale. If the supply of current to the coil is interrupted, region 1a will revert to initial dimensions, and if no current is supplied to the magnetic coil situated just opposite the adjacent region 1b, section 1a will revert to initial conditions as well with respect to dimensions as with respect to position, i.e. the position illustrated in fig 1A.

If the magnetic coil 3 situated just opposite the next adjacent region 1b is supplied with current simultaneously with or in connection with the interruption of current supply to the magnetic coil situated just opposite region 1a, region 1b increases in length and is simultaneously subjected to transverse contraction resulting in that the interface between the regions 1a and 1b, represented in the figures by a dash-and-dot line, is moved in the forward direction in the intended direction of movement. Region 1a returns to initial dimensions in the longitudinal and transverse directions, but remains in the forwardly advanced position, resulting in the position illustrated in fig 1C.

The method steps described above are then repeated sequentially, one after the other, for each one of the regions 1a-1e as illustrated in figures 1A-1G. When the position illustrated in fig 1G has been attained, the magnetostrictive rod 1 thus has moved a distance δ1 in the intended direction of movement.

The method is then repeated, starting with region 1a.

Since each one of the regions 1a-1e in fact only represent a small fraction of the total length of the magnetostrictive rod 1, it should be obvious that the clamping grip of the magnetostrictive rod 1 against the inside of tube 2 remains substantially unchanged during the displacement.

By controlling the supply of current to the magnetic coils 3 so that the method steps described above are repeated sequentially, one after the other, the magnetostrictive rod 1 may be made to move over the desired distance within the tube 2. If the magnitude of the respective magnetic field is adjusted so that the respective region 1a-1e which is influenced, is caused to lose its clamping grip against the inside of tube 2, the movement of the magnetostrive rod 1 takes place without sliding friction. If tube 2 is supported by a rigid supporting construction and the magnetostrictive rod 1 by means of a bar is connected to a working tool, the magnetostrictive rod 1 can be made to exert a power actuation on the working tool in the intended direction of movement. The magnitude of this actuating force depends i.a. on the clamping grip between the tube 2 and the magnestrictive rod 1.

The movement of the magnetostrictive rod may be controlled in a very simple manner by controlling the supply of current to the coils 3.

In the embodiment illustrated in the figures, the magnetostrictive rod 1 is clamped within the tube 2 by means of shrinking. The method according to the invention may, however, be applied in a corresponding way as described above also to an embodiment, in which the magnetostrictive rod consists of a hollow body which is shrunk upon a rod extending through the hollow body and preferably consisting of non-magnetic material.

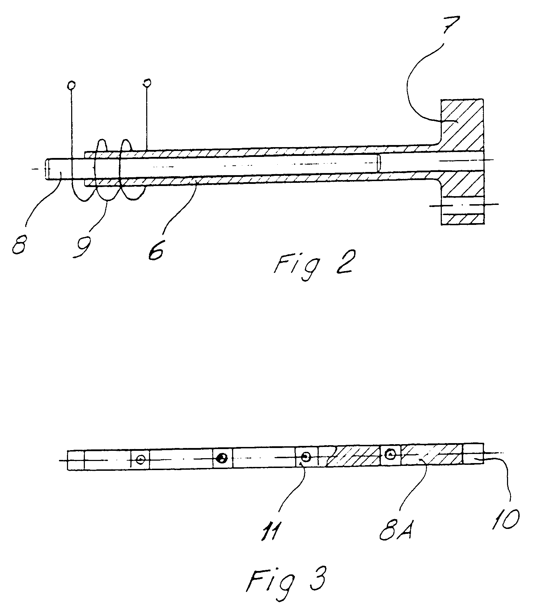

Figures 2 and 3 illustrate a translation motor in which the method according to the invention is applied.

As appears in fig 2 the motor includes a tubular portion 6, one end of which being provided with a flange 7 for attaching the tubular portion 6 to a rigid support. In the bore of the tubular portion 6, a magnetostrictive rod 8 is clamped by tight fit, the magnetostrictive rod protruding outside the end of the tubular portion 6 and is connected to the tool or other means to be actuated when the rod 8 is being displaced.

In order to accomplish the movement of rod 8, use is made of a magnetic coil 9 surrounding the tubular portion 6 and being connectable to a source of electric current. When current is supplied to the coil a magnetic field is generated and the part of the rod 8 which is influenced by the magnetic field will be subject to elongation and at the same time contraction in the radial direction. It is of course possible to displace the coil 9 along the tube 6 and thus accomplish a wormlike movement of displacement of rod 8. In practice, however, it is more convenient to have a number of magnetic coils positioned along the tube, and to supply the magnetic coils sequentially, one after the other, with current in order to accomplish the displacement of the rod 8 within the tube 6 in the manner described previously.

In the embodiment illustrated in fig 3 the magnetostrictive rod 8 is divided into a plurality of regions 8a, which are interconnected by means of a prestressing wire 10 via attachment pieces 11 disposed between adjacent regions 8a. This results in that each one of the regions 8a as well as rod 8 is subject to the desired prestressing in the axial direction of rod 8 and over the entire length thereof. As mentioned previously the prestressing is needed in order to accomplish that the rod, after having been influenced by the magnetic fields, shall return to its initial dimensions. The prestressing may, however, be accomplished in many different ways, and fig 3 only illustrates one example of such prestressing.

As appears from the foregoing it is a preferred feature according to the invention that the rod 1, 8 consists of a magnetostrictive material. Preferably the rod 1, 8 is made of so called giant magnetostrictive material, e.g. an alloy of rare earth metals such as samarium (Sm), terbium (Tb), dysprosium (Dy), holmium (Ho), erbium (Er), tulium (Tm) and magnetic transition metals such as iron (Fe), cobalt (Co) and nickel (Ni). This group of alloys presents the largest magnetostriction known so far, e.g. possessing the property to undergo a change in dimension under the influence of a magnetic field, said change in dimension being proportional to the intensity of the magnetic field. It has been found that the magnitude of the magentostriction in these materials is of a quite different range than is the case in ordinary magnetostrictive materials, e.g. iron-nickel. As an example it may thus be mentioned that for a certain magnetic field iron-nickel undergoes a change in length of 20 - 30 µm/m, whereas an alloy of e.g. terbium-dysprosium-iron undergoes a change in length of 2400 µm/m. The change in length to which said giant magnetostrictive materials are subject under the influence of the magnetic field may be positive or negative, e.g. may for certain of said compositions result in an increase in length and for other of said compositions result in a decrease in length. In the present invention, however, it is preferred to use giant magnetostrictive materials of the kind being subject to an increase in length under the influence of a magnetic field. Within the group of giant magnetostrictive materials the magnitude of the magnetostriction under the influence of a certain magnetic field varies, and it is of course preferred in the embodiments according to the present invention to use giant magnetostrictive materials having the largest magnetostrictive properties.

As mentioned previously it is necessary in order to obtain a satisfactory result that the magnetostrictive element used for generating the movement is prestressed in a direction opposite the direction of movement. The prestressing thus neutralises mechanical hysteresis in the magnetostrictive material. In accordance with an alternative to the embodiment described with reference to fig 3 for providing said prestressing, the rod may consist of plates or sheets of magnetostrictive material extending in the longitudinal direction of the rod, said plates or sheets being glued together via intermediate layers of fibrous material. During the manufacture of said laminated rods, the plates or sheets of magnetostrictive material are preloaded in the axial direction and are connected in prestressed condition to the intermediate fibrous layers by means of gluing. As an alternative it is possible instead to impose a traction force on the fibres before and during the gluing operation. The preloading is then released when the glue has become hard, i.e. has cured. In such a rod each section of the laminated rod is prestressed as intended. An additional advantage with laminated rods is that the lamination results in a reduction of eddy current losses.

The invention is not limited to the embodiments described with reference to the figures, but may be subject to variations within the scope of the appended claims. The magnetostrictive body may thus be clamped between two plane-parallel plates, and by using the magnetic field in the principal way described previously, the magnetostrictive body may be caused to move between the plates in the planes thereof, the clamping grip with respect to the plates being kept substantially unchanged. Possibly the grip between the magnetostrictive body and the plate may be obtained solely through the dead weight of the body. In the latter case the body is only resting upon and supported by a plane plate and does not need to be clamped between to plane-parallel plates.

## Claims

1. Method of causing a first body (1, 8) having magnetostrictive properties and a second body (2, 6), against which said first body is in bearing contact with a predetermined grip between the contact surfaces, to move with respect to each other **characterized** in that a magnetic field is made to influence sequentially one after the other of adjacent partial regions (1a-1e) along said first body (1, 8), starting with the front end of the body as seen in the intended direction of movement, said magnetic field being adjusted so that under the influence of the magnetic field each respective partial region undergoes an increase in length and simultaneously a contraction in the transverse direction, the magnitude of the contraction being sufficient to decrease, or preferably eliminate, the grip between said bodies at the respective partial region.

2. Method as claimed in claim 1, **characterized** in that said first body (1, 8) is shaped as a rod and said secondary body as a hollow body (2, 6), said rod being clamped within the hollow body between the walls thereof with a predetermined clamping grip in the transverse direction of the rod.

3. Method as claimed in claim 1, **characterized** in that said first body (1, 8) is shaped as a hollow body and said secondary body (2, 6) as a rod, said hollow body encircling the rod and being clamped against the rod in the transverse direction thereof and with a predetermined clamping grip.

4. Method as claimed in any of claims 1 - 3, **characterized** in that said first body (1, 8) of a material having magnetostrictive properties is mechanically pre-stressed, said pre-stressing being directed opposite the increase in length caused by the magnetic field.

5. Device for carrying out the method according to claims 1 - 4, comprising
- a first body (1, 8) of a material having magnetostrictive properties, and a second body (2, 6), preferably from non-magnetic material, said both bodies being arranged in bearing contact with each other with a predetermined grip between the contact surfaces, characterised by
- means (3, 9) for generating a magnetic field and for causing the magnetic field to sequentially influence one after the other of adjacent partical regions of said first body (1, 8), starting from the front end of the body as seen in the intended direction of movement, and for adjusting the magnetic field so that the respective partial region under the influence of the magnetic field undergoes an increase in length and simultaneously a contraction in the transverse direction of a magnitude sufficient to decrease, or preferably eliminate the grip between said bodies, at the respective partial region.

6. Device as claimed in claim 5, **characterized** in that said means for generating a magnetic field includes a number of magnet coils (3, 9) disposed adjacent each other, said magnet coils surrounding said first and said second bodies which are arranged in contact with each other, each magnet coil (3, 9) being separately connectable to an electric source of current.

7. Device as claimed in claims 5 or 6, **characterized** in that said first body (1, 8) consists of a rod of magnetostrictive material, which is clamped within a tubular body (2, 6) with a predetermined clamping grip between the rod the inside of the tube walls.

8. Device as claimed in claim 7, **characterized** in that said tubular body (6) is attached to a rigid supporting structure, said magnetostrictive rod which is clamped within the tubular body being connected to a rod, a link etc., the opposite end of which being connected with the element to be actuated when the rod is made to move within the tubular body.

9. Device as claimed in claims 5 or 6, **characterized** in that said first body (1, 8) consists of a hollow body and said second body (2, 6) of a rod, said hollow body of magnetostrictive material surrounding said rod and being clamped against the latter with a certain clamping grip between the contact surfaces between the hollow body and the rod.

10. Device as claimed in any of claims 5 or 6, **characterized** in that said first body (1, 8) having magnetostrictive properties includes at least one plane surface by means of which the body is in bearing contact against a supporting surface and is pressed against the supporting surface so that a certain grip is obtained between the contact surfaces.

11. Device as claimed in claim 10, **characterized** in that said first body (1, 8) includes two planar parallel surfaces and is clamped between two plane parallel plates so that a certain grip is obtained between the contact surfaces.

12. Device as claimed in any of claims 5 - 11, **characterized** in that said first body (1, 8) having magnetostrictive properties is pre-stressed with a compressive stress acting in a direction opposite the direction of the increrase in length to which the body is subject under the influence of said magnetic field.

13. Device as claimed in any of claims 5 - 12, **characterized** in that said first body (1, 8) includes a plurality of partial regions (8a) and partial pieces (11) disposed on opposite sides of each partial region, a prestressing bar (10), e.g. a pre-stressing wire, extending axially through all partial pieces (11) and partial regions (8a) and being attached in prestressed condition to each one of said partial pieces (11).

14. Device as claimed in any of claims 5 - 12, **characterized** in that said first body (1, 8) includes a number of sheets of magnetostrictive material extending in the longitudinal direction of the body, said sheets being attached to each other by means of gluing via intermediate fibre layers under simultaneous pre-stressing by compressing the sheets in the longitudinal direction thereof.

15. Device as claimed in any of claims 5 - 12, **characterized** in that said first body (1, 8) includes a number of sheets of magnetostrictive material extending in the longitudinal direction of the body, said sheets being laminated and glued together with intermediate fibre layers, said fibres being subject to a tractional force before and during the gluing operation.

16. Device as claimed in any of claims 5 - 15 claims, **characterized** in that said first body (1, 8) having magnetostrictive properties completely or partially is made of a giant magnetostrictive material, i.e. of an alloy between rare earth metals, such as samarium (Sm), terbium (Tb) dysprosium (Dy), holmium (Ho), erbium (Er), tulium (Tm) and magnetic transition metals such as iron (Fe), cobalt (Co) and nickel (Ni).

## Patentansprüche

1. Verfahren zum Verschieben eines ersten Körpers (1,8) mit magnetostriktiven Eigenschaften und eines zweiten Körpers (2, 6), gegen den der erste Körper mit einem vorbestimmten Griff zwischen den Berührungs- oder Anlageflächen in Lagerberührung steht, relativ zueinander, dadurch gekennzeichnet, daß ein Magnetfeld zur sequentiellen Einwirkung nacheinander auf benachbarte Teilbereiche (1a - 1e) längs des ersten Körpers (1, 8), ausgehend vom Vorderende des Körpers, in der vorgesehenen Verschieberichtung gesehen, gebracht wird, und das Magnetfeld so eingestellt wird, daß jeder betreffende Teilbereich unter dem Einfluß des Magnetfelds einer Längenvergrößerung und gleichzeitig einer Zusammenziehung in der Querrichtung unterliegt, wobei die Größe der Zusammenziehung ausreichend ist, um den Griff zwischen den Körpern am jeweiligen Teilbereich zu verkleinern oder vorzugsweise aufzuheben.

2. Verfahren nach Anspruch 1, dadurch gekennzeichnet, daß der erste Körper (1, 8) als Stab oder Stange und der sekundäre bzw. zweite Körper als Hohlkörper (2, 6) geformt sind, wobei die Stange innerhalb des Hohlkörpers zwischen seinen Wänden mit einem vorbestimmten Spanngriff in der Querrichtung der Stange verspannt ist.

3. Verfahren nach Anspruch 1, dadurch gekennzeichnet, daß der erste Körper (1, 8) als Hohlkörper und der sekundäre oder zweite Körper (2, 6) als Stange geformt sind, wobei der Hohlkörper die Stange umschließt und gegen die Stange in deren Querrichtung mit einem vorbestimmten Spanngriff verspannt ist.

4. Verfahren nach einem der Ansprüche 1 bis 3, dadurch gekennzeichnet, daß der erste Körper (1, 8) aus einem Werkstoff mit magnetostriktiven Eigenschaften mechanisch vorgespannt ist oder wird, wobei die Vorspannung entgegengesetzt zu der durch das Magnetfeld hervorgerufenen Längenvergrößerung gerichtet ist.

5. Vorrichtung zur Durchführung des Verfahrens nach den Ansprüchen 1 bis 4, umfassend:
- einen ersten Körper (1, 8) aus einem Werkstoff mit magnetostriktiven Eigenschaften und einen vorzugsweise aus einem nichtmagnetischen Werkstoff bestehenden Körper (2, 6), wobei die beiden Körper in Anlage- oder Lagerberührung miteinander mit einem vorbestimmten Griff zwischen den Berührungsflächen angeordnet sind, gekennzeichnet durch
- eine Einheit (3, 9) zum Erzeugen eines Magnetfelds, und um das Magnetfeld sequentiell und nacheinander benachbarte Teilbereiche des ersten Körpers (1, 8), ausgehend vom Vorderende des Körpers, in der vorgesehenen Verschieberichtung gesehen, beeinflussen zu lassen, und zum Einstellen des Magnetfelds in der Weise, daß der betreffende Teilbereich unter dem Einfluß des Magnetfelds einer Längenvergrößerung und gleichzeitig einer Zusammenziehung in der Querrichtung mit einer ausreichenden Größe unterliegt, um den Griff zwischen den Körpern am jeweiligen Teilbereich zu verkleinern oder vorzugsweise aufzuheben.

6. Vorrichtung nach Anspruch 5, dadurch gekennzeichnet, daß die Einheit zum Erzeugen eines Magnetfelds eine Anzahl von nebeneinander angeordneten Magnetspulen (3, 9) aufweist, welche die ersten und zweiten, miteinander in Berührung angeordneten Körper umgeben, wobei jede Magnetspule (3, 9) getrennt mit einer elektrischen Stromquelle verbindbar ist.

7. Vorrichtung nach Anspruch 5 oder 6, dadurch gekennzeichnet, daß der erste Körper (1, 8) aus einer Stange aus magnetostriktivem Werkstoff besteht, welche innerhalb eines rohrförmigen Körpers (2, 6) mit einem vorbestimmten Spanngriff zwischen der Stange und der Innenseite der Rohrwände verspannt ist.

8. Vorrichtung nach Anspruch 7, dadurch gekennzeichnet, daß der rohrförmige Körper (6) an einer steifen Tragstruktur angebracht ist, (und) die innerhalb des rohrförmigen Körpers verspannte magnetostriktive Stange mit einer Stange, einem Lenker o.dgl. verspannt ist, deren bzw. dessen gegenüberliegendes Ende mit dem bei Verschiebung der Stange innerhalb des rohrförmigen Körpers zu betätigenden Element verbunden ist.

9. Vorrichtung nach Anspruch 5 oder 6, dadurch gekennzeichnet, daß der erste Körper (1, 8) aus einem Hohlkörper und der zweite Körper (2, 6) aus einer Stange bestehen, (und) der Hohlkörper aus magnetostriktivem Werkstoff die Stange umgibt und gegen letztere mit einem bestimmten Spanngriff zwischen den Berührungsflächen zwischen Hohlkörper und Stange verspannt ist.

10. Vorrichtung nach einem der Ansprüche 5 oder 6, dadurch gekennzeichnet, daß der magnetostriktive Eigenschaften aufweisende erste Körper (1, 8) mindestens eine Planfläche aufweist, über welche der Körper in Anlage- oder Lagerberührung gegen eine Stützfläche steht und an letztere so angepreßt ist, daß zwischen den Berührungsflächen ein bestimmter Griff hergestellt ist.

11. Vorrichtung nach Anspruch 10, dadurch gekennzeichnet, daß der erste Körper (1, 8) zwei planparallele Flächen aufweist und zwischen zwei planparallelen Platten so verspannt ist, daß zwischen den Berührungsflächen ein bestimmter Griff hergestellt ist.

12. Vorrichtung nach einem der vorangehenden Ansprüche 5 bis 11, dadurch gekennzeichnet, daß der magnetostriktive Eigenschaften aufweisende erste Körper (1, 8) mit einer Druckspannung vorgespannt ist, die in einer Richtung entgegengesetzt zur Richtung der Längenvergrößerung wirkt, welcher der Körper unter dem Einfluß des Magnetfelds unterworfen ist.

13. Vorrichtung nach einem der vorangehenden Ansprüche 5 bis 12, dadurch gekennzeichnet, daß der erste Körper (1, 8) eine Anzahl von Teilbereichen (8a) und auf gegenüberliegenden Seiten jedes Teilbereichs angeordnete Teilstücke (11) umfaßt, wobei ein Vorspannstab (10), z.B. ein Vorspanndraht, sich axial durch alle Teilstücke (11) und Teilbereiche (8a) erstreckt und in vorgespanntem Zustand an jedem der Teilstücke (11) angebracht ist.

14. Vorrichtung nach einem der Ansprüche 5 bis 12, dadurch gekennzeichnet, daß der erste Körper (1, 8) eine Anzahl von sich in der Längsrichtung des Körpers erstreckenden Lagen oder Blechen aus magnetostriktivem Werkstoff aufweist, welche Lagen oder Bleche durch Kleben über zwischengefügte Faserschichten mit gleichzeitiger Vorspannung durch Zusammenpressen der Lagen oder Bleche in ihrer Längsrichtung aneinander angebracht sind.

15. Vorrichtung nach einem der Ansprüche 5 bis 12, dadurch gekennzeichnet, daß der erste Körper (1, 8) eine Anzahl von sich in der Längsrichtung des Körpers erstreckenden Lagen oder Blechen aus magnetostriktivem Werkstoff aufweist, welche Lagen oder Bleche laminiert und mit zwischengefügten Faserschichten miteinander verklebt sind, wobei die Fasern vor dem und während des Klebevorgang(s) einer Zugkraft unterworfen sind oder werden.

16. Vorrichtung nach einem der vorangehenden Ansprüche 5 bis 15, dadurch gekennzeichnet, daß der erste Körper (1, 8) mit magnetostriktiven Eigenschaften vollständig oder teilweise aus einem Riesen-magnetostriktiven Werkstoff hergestellt ist, d.h. einer Legierung zwischen (von) Seltenen Erdemetallen, wie Samarium (Sm), Terbium (Tb), Dysprosium (Dy), Holmium (Ho), Erbium (Er), Tulium (Tm), und magnetischen Übergangsmetallen, wie Eisen (Fe), Kobalt (Co) und Nickel (Ni).

## Revendications

1. Procédé pour provoquer le mouvement d'un premier corps (1, 8) ayant des propriétés magnétostrictives et un second corps (2, 6), contre lequel ledit premier corps est en contact d'appui avec une préhension prédéterminée entre les surfaces de contact, l'un par rapport à l'autre, caractérisé en ce qu'un champ magnétique est amené a influencer séquentiellement l'une après l'autre de zones partielles contiguës (1a - 1e) le long dudit premier corps (1, 8), en commençant par l'extrémité avant du corps telle qu'elle est vue dans le sens attendu du mouvement, ledit champ magnétique étant ajusté de façon que sous l'influence du champ magnétique chaque zone partielle respective subisse un accroissement de la longueur et simultanément une contraction dans le sens transversal, l'amplitude de la contraction étant suffisante pour diminuer, voire de préférence éliminer, la préhension entre lesdits corps au droit de la zone partielle respective.

2. Procédé selon la revendication 1, caractérisé en ce que ledit premier corps (1, 8) est façonné comme une tige et ledit corps secondaire comme un corps creux (2, 6), ladite tige étant serrée dans le corps creux entre ses parois avec une préhension de serrage prédéterminée dans le sens transversal de la tige.

3. Procédé selon la revendication 1, caractérisé en ce que ledit premier corps (1, 8) est façonné comme un corps creux et ledit corps secondaire (2, 6) comme une tige, ledit corps creux entourant la tige et étant serré contre la tige dans le sens transversal de celle-ci avec une préhension de serrage prédéterminée.

4. Procédé selon l'une quelconque des revendications 1 - 3, caractérisé en ce que ledit premier corps (1, 8) en matériau ayant des propriétés magnétostrictives est mécaniquement précontraint, ladite précontrainte étant dirigée à l'opposé de l'augmentation de la longueur provoquée par le champ magnétique.

5. Dispositif pour exécuter le procédé selon les revendications 1 - 4, comprenant :
un premier corps (1, 8) en matériau ayant des propriétés magnétostrictives (20), et un second corps (2, 6), de préférence en matériau amagnétique, lesdits deux corps étant disposés en contact d'appui l'un avec l'autre avec une préhension prédéterminée entre les surfaces de contact, caractérisé par :
un moyen (3, 9) pour engendrer un champ magnétique et pour amener le champ magnétique à influencer séquentiellement l'une après l'autre de zones partielles contiguës dudit premier corps (1, 8), en commençant par l'extrémité avant du corps telle qu'elle est vue dans le sens attendu du mouvement, et pour ajuster le champ magnétique de façon que la zone partielle respective sous l'influence du champ magnétique subisse un augmentation de longueur et simultanément une contraction dans le sens transversal d'une amplitude suffisante pour diminuer, voire de préférence éliminer, la préhension entre lesdits corps, au droit de la zone partielle respective.

6. Dispositif selon la revendication 5, caractérisé en ce que ledit moyen pour engendrer un champ magnétique comprend un certain nombre de bobines magnétiques (3, 9) disposées en étant contiguës les unes aux autres, lesdites bobines magnétiques entourant lesdits premier et second corps qui sont disposés en contact l'un avec l'autre, chaque bobine magnétique (3, 9) pouvant être connectée séparément à une source de courant électrique.

7. Dispositif selon les revendications 5 ou 6, caractérisé en ce que ledit premier corps (1, 8) est constitué d'une tige en matériau magnétostrictif, qui est serrée dans un corps tubulaire (2, 6) avec une préhension de serrage prédéterminée entre la tige et l'intérieur des parois du tube.

8. Dispositif selon la revendication 7, caractérisé en ce que ledit corps tubulaire (6) est fixé à une structure de support rigide, ladite tige magnétostrictive qui est serrée dans le corps tubulaire étant connectée à une tige, une biellette, etc., dont l'extrémité opposée est reliée à l'élément devant être actionné lorsque la tige est amenée à se déplacer à l'intérieur du corps tubulaire.

9. Dispositif selon les revendications 5 ou 6, caractérisé en ce que ledit premier corps (1, 8) est constitué d'un corps creux et ledit second corps (2, 6) d'une tige, ledit corps creux en matériau magnétostrictif entourant ladite tige et étant serré contre cette dernière avec une certaine préhension de serrage entre les surfaces de contact entre le corps creux et la tige.

10. Dispositif selon l'une quelconque des revendications 5 ou 6, caractérisé en ce que ledit premier corps (1,8) présentant des propriétés magnétostrictives comprend au moins une surface plane au moyen de laquelle le corps est en contact d'appui contre une surface de support et est comprimé contre la surface de support de sorte qu'une certaine préhension est obtenue entre les surfaces de contact.

11. Dispositif selon la revendication 10, caractérisé en ce que ledit premier corps (1, 8) comporte deux surfaces planes parallèles et est serré entre deux plaques planes parallèles de façon qu'une certaine préhension soit obtenue entre les surfaces de contact.

12. Dispositif selon l'une quelconque des revendications 5 - 11, caractérisé en ce que ledit premier corps (1, 8) présentant des propriétés magnétostrictives est précontraint avec une contrainte de compression agissant dans une direction opposée au sens de l'augmentation de longueur à laquelle le corps est soumis sous l'influence dudit champ magnétique.

13. Dispositif selon l'une quelconque des revendications 5 - 12, caractérisé en ce que ledit premier corps (1, 8) comprend une multitude de zones partielles (8a) et des pièces partielles (11) disposées sur les côtés opposés de chaque zone partielle, une barre précontrainte (10), par exemple un fil de précontrainte, s'étendant axialement à travers toutes les pièces partielles (11) et les zones partielles (8a) et étant fixée dans un état précontraint a chacune desdites pièces partielles (11).

14. Dispositif se on l'une quelconque des revendications 5 à 12, caractérisé en ce que ledit premier corps (1, 8) comprend un certain nombre de feuilles en matériau magnétostrictif s'étendant dans le sens longitudinal du corps, lesdites feuilles étant fixées les unes au autres par collage via des couches intermédiaires de fibres sous une précontrainte simultanée par compression des feuilles dans leur direction longitudinale.

15. Dispositif selon l'une quelconque des revendications 5-12, caractérisé en ce que ledit premier corps (1, 8) comprend un certain nombre de feuilles en matériau magnétostrictif s'étendant dans le sens longitudinal du corps, lesdites feuilles étant laminées et collées ensemble avec des couches intermédiaires de fibres, lesdites fibres étant soumises à une force de traction avant et pendant l'opération de collage.

16. Dispositif selon l'une quelconque des revendications 5 - 15, caractérisé en ce que ledit premier corps (1, 8) présentant des propriétés magnétostrictives complètement ou partiellement est constitué d'un matériau magnétostrictif géant, c'est-à-dire d'un alliage entre métaux des terres rares, tels que le samarium (Sm), le terbium (Tb), le disprosium (Dy), l'holmium (Ho) l'erbium (Er), le tulium (Tm) et les métaux de transition magnétiques tels que le fer (Fe), le cobalt (Co) et le nickel (Ni).
